# EUROPÄISCHE PATENTSCHRIFT

(11) **EP 0 489 935 B1**
(45) Veröffentlichungstag und Bekanntmachung des Hinweises auf die Patenterteilung: **02.11.1995**
(21) Anmeldenummer: 90121498.1
(22) Anmeldetag: 09.11.1990
(51) Int. Cl.: H03K 17/06, H03K 17/08, H03K 17/687

(54) **MOSFET-Schalter für eine induktive Last**
MOSFET switch for an inductive load
Commutateur MOSFET pour une charge inductive

(43) Veröffentlichungstag der Anmeldung: 17.06.1992
(73) Patentinhaber: SIEMENS AKTIENGESELLSCHAFT, 80333 München (DE)
(72) Erfinder: Leipold, Ludwig, Dipl.-Ing., W-8000 München 40 (DE); Rothleitner, Hubert, Dipl.-Ing., A-Villach (AT); Sander, Rainald, Dipl.-Phys., W-8000 München 40 (DE); Tihanyi, Jenö, Dr., W-8000 München 21 (DE)

(56) Entgegenhaltungen:
- EP-A- 0 239 862
- EP-A- 0 336 194
- EP-A- 0 352 828

## Beschreibung

Die Erfindung bezieht sich auf eine Schaltungsanordnung mit einem Leistungs-MOSFET und einer induktiven Last, die einerseits mit dem Sourceanschluß und andererseits mit einer auf festem Potential liegenden Klemme verbunden ist, und mit einer aus einer Zenerdiode und einem, zum Abschalten der induktiven Last steuerbaren, Schalter bestehenden Reihenschaltung, die zwischen Gateanschluß und die Klemme geschaltet ist.

Eine solche Schaltungsanordnung ist beispielsweise in der europäischen Patentschrift 0 239 861 beschrieben worden. Geht man von einer stromdurchflossenen induktiven Last aus, so wird das Abschalten der induktiven Last durch Einschalten des steuerbaren Schalters eingeleitet. Dieser entlädt die Gate-Sourcekapazität des Leistungs-MOSFET, der damit zu sperren beginnt. Der Strom durch die induktive Last fließt zunächst weiter und baut an der Zenerdiode eine Spannung in Sperrichtung auf, die bis zur Zenerspannung ansteigen kann. Die an der induktiven Last anliegende treibende Spannung ist daher die Zenerspannung zuzüglich der am steuerbaren Schalter abfallenden Spannung zuzüglich der Gate-Sourcespannung am Leistungs-FET. Die treibende Spannung an der induktiven Last kann daher im wesentlichen durch die Wahl der Zenerspannung eingestellt werden. Bei einer hohen Zenerspannung wird dann die magnetische Energie schnell abgebaut.

Wird der Leistungs-MOSFET durch einen elektronischen Schalter betrieben, so liegt der Gateanschluß des Leistungs-MOSFET im abgeschalteten Zustand auf Null Volt. Kehrt sich nun die Spannung an der induktiven Last um, so kann, bevor die Zenerdiode ihre Zenerspannung erreicht, der Leistungs-MOSFET bereits dann wieder einschalten, wenn sein Sourcepotential um die Einsatzspannung unter Null gefallen ist. Die treibende Spannung an der induktiven Last ist daher in diesem Fall auf einen Wert begrenzt, der der Einsatzspannung des Leistungs-MOSFET entspricht. Die magnetische Energie wird daher in diesem Fall nur langsam abgebaut.

Ziel der Erfindung ist es, eine Schaltungsanordnung der beschriebenen Art so weiterzubilden, daß ein Einschalten des Leistungs-MOSFET sicher verhindert wird, solange die in Sperrichtung an der Zenerdiode anstehende Spannung unter der Zenerspannung liegt.

Dieses Ziel wird erreicht durch einen steuerbaren Widerstand zwischen Gateanschluß und Sourceanschluß, dessen Widerstandswert, beim Abschalten der Last, derart gesteuert wird, daß er bei einem bei Durchbruch der Zenerdiode fließenden Strom einen ersten hohen Wert und unterhalb dieses Stroms einen zweiten, niedrigeren Wert hat.

Weiterbildungen der Erfindung sind Gegenstand der abhängigen Ansprüche.

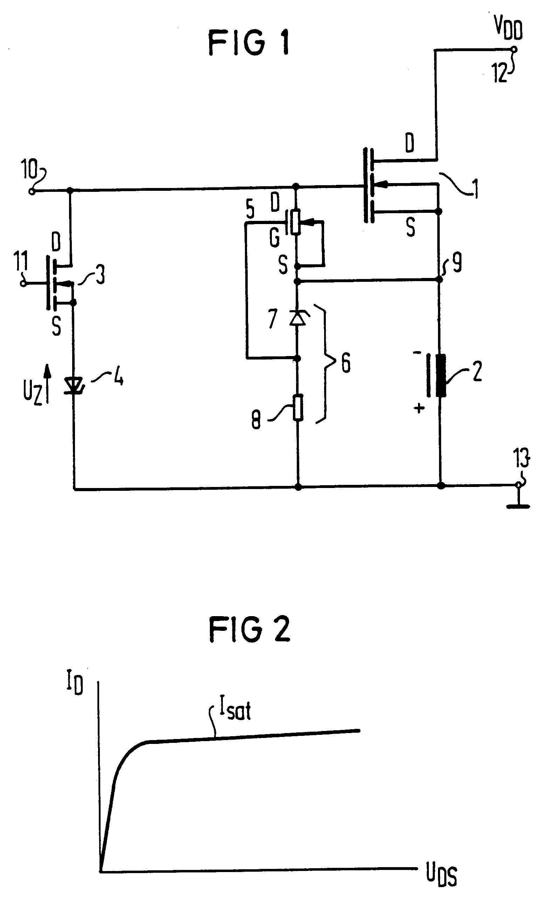

Die Erfindung wird anhand eines Ausführungsbeispiels in Verbindung mit den FIG 1 und 2 näher erläutert. Es zeigen FIG 1 eine Schaltungsanordnung gemäß der Erfindung und FIG 2 die U/I-Kennlinie eines steuerbaren Widerstandes.

Die Schaltungsanordnung nach FIG 1 enthält einen Leistungs-MOSFET 1, dem sourceseitig eine induktive Last 2 in Reihe geschaltet ist. Die Reihenschaltung liegt über zwei Klemmen 12, 13 an einer Betriebsspannung V_{DD}. Die Klemme 13 liegt auf festem Potential, z. B. an Masse. Zwischen dem Gateanschluß des Leistungs-MOSFET 1 und der Klemme 13 ist eine aus einem MOSFET 3 und einer Zenerdiode 4 bestehende Reihenschaltung angeschlossen. Die Zenerdiode 4 ist derart gepolt, daß sie durch die beim Abschalten der induktiven Last 2 entstehende treibende Spannung in Sperrichtung beansprucht wird. Der Gateanschluß des Leistungs-MOSFET ist mit einer Klemme 10 verbunden, der Gateanschluß des MOSFET 3 mit einer Klemme 11.

Zwischen Gateanschluß und Sourceanschluß des Leistungs-MOSFET 1 liegt ein n-Kanal-Depletion-MOSFET 5. Der Sourceanschluß des Depletion-MOSFET 5 ist mit seinem Substrat verbunden. Sein Gateanschluß ist mit dem Abgriff eines Spannungsteilers 6 verbunden, der der induktiven Last 2 parallel geschaltet ist. Der Spannungsteiler 6 besteht aus einer Zenerdiode 7 und einem Widerstand 8. Die Zenerdiode 7 kann jedoch auch durch einen Widerstand ersetzt werden.

Zum Einschalten der induktiven Last 2 wird an die Klemme 10 eine positive Spannung gelegt, die größer ist als die Betriebsspannung V_{DD}. Sie kann z. B. durch eine bekannte Pumpschaltung geliefert werden.

Soll die induktive Last abgeschaltet werden, so wird der steuerbare Schalter 3 durch eine an die Klemme 11 gelegte Spannung leitend gesteuert. Damit wird die Gate-Sourcekapazität des Leistungs-MOSFET 1 entladen und dieser beginnt zu sperren. An der induktiven Last 2 baut sich eine Spannung mit der eingezeichneten Polarität auf. Die Spannung am Sourceanschluß des Leistungs-MOSFET 1 (Knoten 9) wird also negativ bezüglich seiner Gatespannung, da sein Gate über die Klemme 10 auf Null Volt liegt. Damit könnte der Leistungs-MOSFET 1 wieder eingeschaltet werden.

Dies wird durch den Depletion-FET 5 verhindert. Dieser ist als Stromquelle geschaltet; sein Sourceanschluß ist mit dem Substrat verbunden. Er ist derart dimensioniert, daß sein Sättigungsstrom Iₛₐₜ (FIG 2) größer ist als der Sperrstrom, der durch die Zenerdiode 4 fließt, wenn diese noch nicht durchgebrochen ist. Der Sättigungsstrom ist jedoch kleiner als derjenige Strom, der bei Durchbruch der Zenerdiode 4 fließen würde.

Die nach dem Einschalten des MOSFET 3 und dem Sperren des Leistungs-MOSFET 1 an der induktiven Last 2 anstehende Spannung treibt zunächst einen Strom durch die Zenerdiode 4, den MOSFET 3 und den Depletion-FET 5, der kleiner ist als der Sättigungsstrom des Depletion-FET. An ihm fällt daher nur eine geringe Drain-Sourcespannung ab. Der Gateanschluß und der Sourceanschluß des Leistungs-MOSFET 1 befindet sich damit praktisch auf gleichem Potential, so daß er gesperrt bleibt. Steigt die Spannung an der induktiven Last 2 weiter an, so wird die Zenerspannung U_{Z} der Zenerdiode 4 erreicht und diese bricht durch. Damit steigt der durch die Zenerdiode 4, den MOSFET 3 und den Depletion-FET 5 getriebene Strom an, bis der Sättigungsstrom des Depletion-FET erreicht ist. Dabei nimmt die Drain-Sourcespannung des Depletion-FET zu und der Leistungs-MOSFET 1 wird leitend gesteuert, wenn seine Einsatzspannung erreicht wird. Damit kann der Strom der induktiven Last 2 durch die Betriebsspannungsquelle und den Leistungs-MOSFET 1 abfließen. Die treibende Spannung wird dabei durch die Spannung U_{Z} zuzüglich der Drain-Sourcespannung des steuerbaren Schalters 3 zuzüglich der Drain-Sourcespannung des Depletion-FET 5 bestimmt. Sie kann durch entsprechende Auswahl der Zenerdiode 4 eingestellt werden.

Um den Depletion-FET beim Einschalten der Last 2 sicher zu sperren, muß er bei an der Klemme 10 anliegender Steuerspannung einen hohen Durchlaßwiderstand haben. Dies wird dadurch erreicht, daß sein Gateanschluß gegenüber seinem Sourceanschluß über den Spannungsteiler 6 negativ vorgespannt wird. Damit ist der Depletion-FET 5 so lange gesperrt, wie die Spannung am Knoten 9 positiver als an der Klemme 13 ist.

Der MOSFET 3 kann durch einen anderen steuerbaren Schalter, z. B. durch einen Bipolartransistor ersetzt werden. Der Depletion-FET 5 kann auch durch einen anderen steuerbaren Widerstand z. B. einen Bipolartransistor ersetzt werden.

## Patentansprüche

1. Schaltungsanordnung mit einem Leistungs-MOSFET (1) und einer induktiven Last (2), die einerseits mit dem Sourceanschluß und andererseits mit einer auf festem Potential liegenden Klemme (13) verbunden ist, mit einer aus einer Zenerdiode (4) und einem, zum Abschalten der induktiven Last (2) steuerbaren, Schalter (3) bestehenden Reihenschaltung, die zwischen Gateanschluß und die Klemme (13) geschaltet ist,
**gekennzeichnet durch** einen steuerbaren Widerstand (5) zwischen Gateanschluß und Sourceanschluß, dessen Widerstandswert, beim Abschalten der Last (2), derart gesteuert wird, daß er bei einem bei Durchbruch der Zenerdiode (4) fließenden Strom einen ersten, hohen Wert und unterhalb dieses Stroms einen zweiten, niedrigeren Wert hat.

2. Schaltungsanordnung nach Anspruch 1,
**dadurch gekennzeichnet,** daß der steuerbare Widerstand eine Stromquelle ist, deren Strom kleiner als der beim Zenerdurchbruch fließende Strom ist.

3. Schaltungsanordnung nach Anspruch 2,
**dadurch gekennzeichnet,** daß die Stromquelle ein Depletion-FET (5) ist, dessen Sättigungsstrom kleiner als der beim Zenerdurchbruch fließende Strom ist.

4. Schaltungsanordnung nach Anspruch 3,
**dadurch gekennzeichnet,** daß der Gateanschluß des Depletion-FET (5) mit dem Abgriff eines Spannungsteilers (6) verbunden ist, der der induktiven Last (2) parallel geschaltet ist.

## Claims

1. Circuit arrangement having a power MOSFET (1) and an inductive load (2) which is connected, on the one side, to the source connection and, on the other side, to a terminal (13) which is at a fixed potential, having a series circuit, consisting of a Zener diode (4) and a switch (3) which can be controlled in order to turn off the inductive load (2), which is connected between the gate connection and the terminal (13), characterized by a controllable resistor (5) between the gate connection and the source connection, the resistance of which is controlled, when turning off the load (2), such that it has a first, high value when a current flows at breakdown of the Zener diode (4) and, below this current, a second, lower value.

2. Circuit arrangement according to Claim 1, characterized in that the controllable resistor is a current source, the current of which is smaller than the current flowing at Zener breakdown.

3. Circuit arrangement according to Claim 2, characterized in that the current source is a depletion FET (5), the saturation current of which is smaller than the current flowing at Zener breakdown.

4. Circuit arrangement according to Claim 3, characterized in that the gate connection of the depletion FET (5) is connected to the tap of a voltage divider (6) which is connected in parallel with the inductive load (2).

## Revendications

1. Montage comportant un transistor MOSFET de puissance (1) et une charge inductive (2), qui est reliée, d'une part, à la borne de source et, d'autre part, à une borne (13) placée à un potentiel fixe, et un circuit série formé d'une diode Zener (4) et d'un interrupteur commandable (3) servant à débrancher la charge inductive (2) et qui est branché entre la borne de grille et la borne (13),
caractérisé par une résistance commandable (5) disposée entre la borne de grille et la borne de source et dont la valeur résistive est commandée, lors du débranchement de la charge (2), de manière à posséder une première valeur élevée pour un courant circulant lors du claquage de la diode Zener (4), et, au-dessous de ce courant une seconde valeur plus faible.

2. Montage suivant la revendication 1, caractérisé par le fait que la résistance commandable est une source de courant, dont le courant est inférieur au courant circulant lors du claquage de la diode Zener.

3. Montage suivant la revendication 2, caractérisé par le fait que la source de courant est un transistor FET à appauvrissement (5), dont le courant de saturation est inférieur au courant circulant lors du claquage de la diode Zener.

4. Montage suivant la revendication 3, caractérisé par le fait que la borne de grille du transistor FET à appauvrissement (5) est reliée à la prise d'un diviseur de tension (6), qui est branché en parallèle avec la charge inductive (2).
